# EUROPEAN PATENT APPLICATION

(11) **EP 4 654 258 A1**
(43) Date of publication of application: **26.11.2025**
(21) Application number: 24744747.7
(22) Date of filing: 19.01.2024
(51) Int. Cl.: H01L 23/13, H01L 23/12, H01L 23/15, H05K 1/03

(54) **SILICON NITRIDE SUBSTRATE AND SILICON NITRIDE CIRCUIT BOARD USING SAME**

(30) Priority: 20.01.2023 JP 2023007022
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: MATSUMOTO, Ikki, Yokohama-shi, Kanagawa 235-0032 (JP)
(74) Representative: Hoffmann Eitle
(86) International application number: PCT/JP2024/001489
(87) International publication number: WO 2024/154827

(57) **Abstract**

Embodiments are to provide a silicon nitride substrate and a silicon nitride circuit board in which bonding defects can be decreased. When an unevenness of a 6 mm×6 mm portion of at least one surface of a silicon nitride substrate according to an embodiment is observed, a maximum unevenness height, which is the difference between a height of a maximum protrusion and a depth of a maximum recess, is not more than 50 µm. The portion includes a first region in which a height ratio with respect to the maximum unevenness height is not less than 0.8 and not more than 1.0, a second region in which the height ratio is not less than 0.5 but less than 0.8, a third region in which the height ratio is not less than 0.3 but less than 0.5, and a fourth region in which the height ratio is not less than 0 but less than 0.3. A ratio of an area of the first region to a total area of the first to fourth regions is not less than 1% and not more than 10%; a ratio of an area of the second region to the total area is not less than 10% and not more than 50%; a ratio of an area of the third region to the total area is not less than 20% and not more than 50%; and a ratio of an area of the fourth region to the total area is not less than 10% and not more than 60%.

## Description

### [Technical Field]

Embodiments below relate to a silicon nitride substrate, and a silicon nitride circuit board using a silicon nitride substrate.

### [Background Art]

The output of power modules mounted in industrial devices is increasing in recent years as the performance of industrial devices increases. Accordingly, the output of semiconductor elements is increasing. The guaranteed operating temperature of a semiconductor element is 125 °C to 150 °C, but there is a possibility of increasing to 175 °C or more in the future. Silicon nitride substrates are being used as the heat generation amount of semiconductor elements increases.

For example, Japanese Patent No. 6293772 (Patent Literature 1) discusses a silicon nitride substrate of which the thermal conductivity is not less than 50 W/m·K, and the three-point bending strength is not less than 600 MPa. In the manufacturing process of the silicon nitride substrate, an α-silicon nitride powder included in the raw material powder is subjected to grain growth into β-silicon nitride crystal grains in a sintering process. The strength of the silicon nitride substrate can be increased by the β-silicon nitride crystal grains becoming complexly entangled after the grain growth.

The three-point bending strengths of aluminum nitride substrates and aluminum oxide substrates are about 300 to 450 MPa. As shown in Patent Literature 1, silicon nitride substrates having thermal conductivities of not less than 50 W/m·K, or even not less than 80 W/m·K also are being developed. Thus, silicon nitride substrates have both high strength and heat dissipation.

On the other hand, surface unevenness is problematic for silicon nitride substrates. β-Silicon nitride crystal grains are slender crystal grains, and so unevenness easily occurs in the surfaces of the silicon nitride substrates. Silicon nitride substrates are used as silicon nitride circuit boards to which metal plates are bonded. For example, in Japanese Patent No. 6789955 (Patent Literature 2), a metal plate is bonded using active metal bonding. Active metal techniques are bonding methods that use a bonding brazing material including an active metal such as titanium, etc. Bonding defects were caused when the surface unevenness of the silicon nitride substrate was large.

For surface unevenness, for example, Japanese Patent No. 3539634 (Patent Literature 3) discusses a silicon nitride substrate of which the difference between hill peak portions and valley bottom portions of the substrate surface was 1.5 to 15 µm.

### [Prior Art Documents]

### [Patent Literature]

Patent Literature 1: Japanese Patent No. 6293772
Patent Literature 2: Japanese Patent No. 6789955
Patent Literature 3: Japanese Patent No. 3539634

### [Summary of Invention]

### [Problem to be Solved by the Invention]

Improvement of the bonding strength has been observed by reducing the surface unevenness of a silicon nitride substrate. On the other hand, further improvement of TCT characteristics is desirable. A phenomenon in which cracks occur in the bonding layer has been occurring when TCT (heat resistance cycle test) is performed. By investigating the cause, it was found that the distribution of the surface unevenness is related to the cause. Embodiments are directed to address such problems, and to provide a silicon nitride substrate in which the distribution of the surface unevenness is controlled.

### [Means for Solving the Problem]

When an unevenness of a 6 mm×6 mm portion of at least one surface of a silicon nitride substrate according to an embodiment is observed, a maximum unevenness height, which is the difference between a height of a maximum protrusion and a depth of a maximum recess, is not more than 50 µm. The portion includes a first region in which a height ratio with respect to the maximum unevenness height is not less than 0.8 and not more than 1.0, a second region in which the height ratio is not less than 0.5 but less than 0.8, a third region in which the height ratio is not less than 0.3 but less than 0.5, and a fourth region in which the height ratio is not less than 0 but less than 0.3. A ratio of an area of the first region to a total area of the first to fourth regions is not less than 1% and not more than 10%; a ratio of an area of the second region to the total area is not less than 10% and not more than 50%; a ratio of an area of the third region to the total area is not less than 20% and not more than 50%; and a ratio of an area of the fourth region to the total area is not less than 10% and not more than 60%.

### [Brief Description of Drawings]

[FIG. 1]

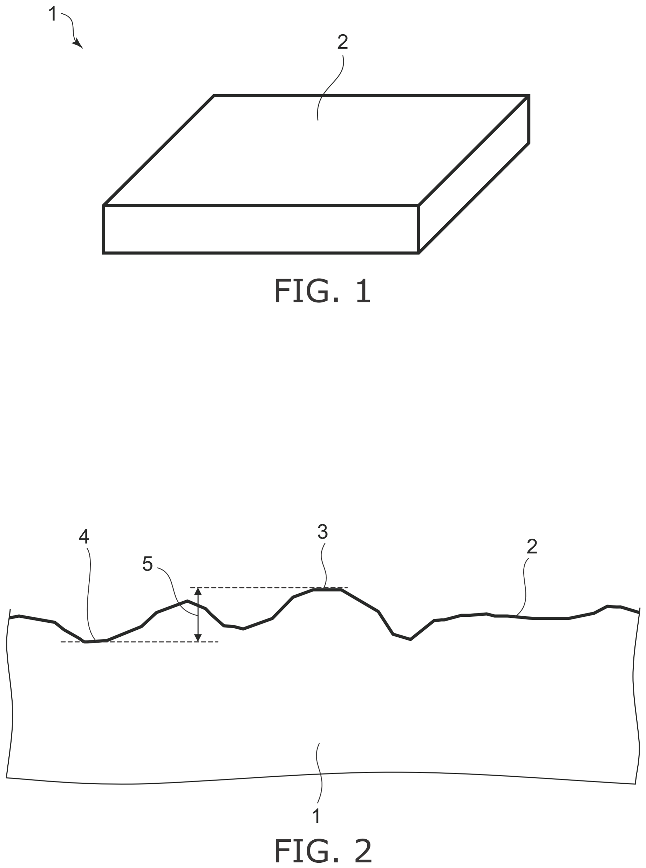

   FIG. 1 is a perspective view showing an example of a silicon nitride substrate according to an embodiment.
[FIG. 2]
   FIG. 2 is a schematic view showing an example of a maximum unevenness height.
[FIG. 3]

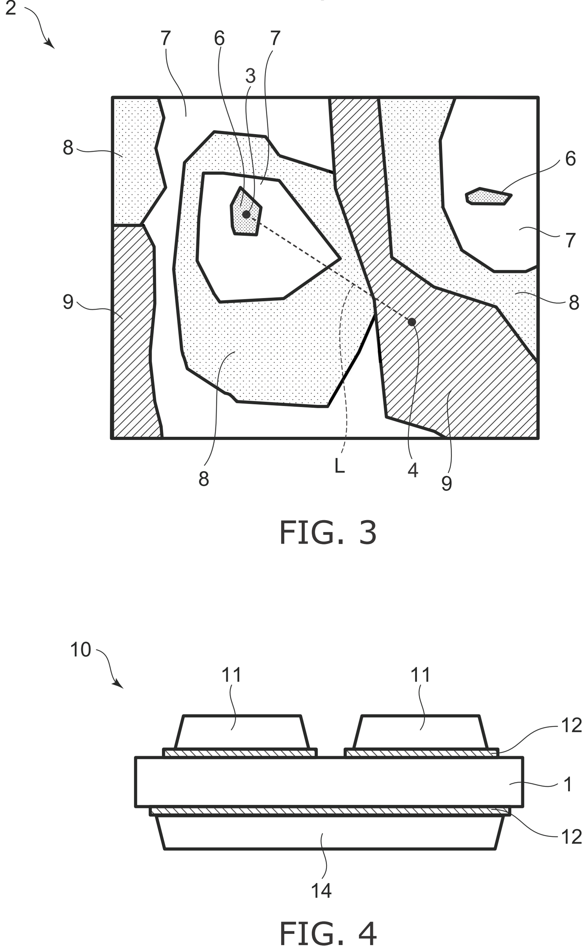

   FIG. 3 is a plan view showing an example of an unevenness distribution of a surface of the silicon nitride substrate.
[FIG. 4]
   FIG. 4 is a side view showing an example of a silicon nitride circuit board according to an embodiment.
[FIG. 5]

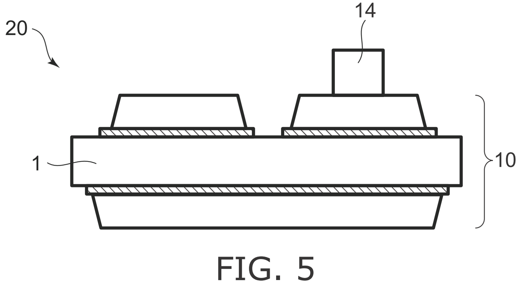

   FIG. 5 is a side view showing an example of a semiconductor device according to an embodiment.

### [Description of Embodiments]

When an unevenness of a 6 mm×6 mm portion of at least one surface of a silicon nitride substrate according to an embodiment is observed, a maximum unevenness height, which is a difference between a height of a maximum protrusion and a depth of a maximum recess, is not more than 50 µm. The portion includes a first region in which a height ratio with respect to the maximum unevenness height is not less than 0.8 and not more than 1.0, a second region in which the height ratio is not less than 0.5 but less than 0.8, a third region in which the height ratio is not less than 0.3 but less than 0.5, and a fourth region in which the height ratio is not less than 0 but less than 0.3. A ratio of an area of the first region to a total area of the first to fourth regions is not less than 1% and not more than 10%; a ratio of an area of the second region to the total area is not less than 10% and not more than 50%; a ratio of an area of the third region to the total area is not less than 20% and not more than 50%; and a ratio of an area of the fourth region to the total area is not less than 10% and not more than 60%.

FIG. 1 is a perspective view showing an example of a silicon nitride substrate according to an embodiment. In FIG. 1, the reference numeral 1 is a silicon nitride substrate, and the reference numeral 2 is a surface. FIG. 1 illustrates the silicon nitride substrate 1 that includes a rectangular surface 2. The shape of the surface 2 is not limited to rectangular and may be various shapes such as square, circular, pentagonal, L-shaped, U-shaped, etc. As described below, the surface 2 of the silicon nitride substrate 1 can be used as a surface at which a circuit part is located.

When the unevenness of a 6 mm×6 mm portion of at least one surface 2 of the silicon nitride substrate 1 is observed, the maximum unevenness height, which is the height difference between the maximum protrusion and the maximum recess, is not more than 50 µm. FIG. 2 is a schematic view showing an example of the maximum unevenness height. In FIG. 2, the reference numeral 2 is a surface, the reference numeral 3 is a maximum protrusion, the reference numeral 4 is a maximum recess, and the reference numeral 5 is a maximum unevenness height.

First, the unevenness of any 6 mm×6 mm portion of the surface 2 is observed. A three-dimensional profilometer is used to observe the unevenness. VR-3000 made by Keyence Corporation or an apparatus having equivalent or better performance is used as the three-dimensional profilometer.

The highest point in the 6 mm×6 mm portion when measured by the three-dimensional profilometer is taken as the maximum protrusion 3. The lowest point is taken as the maximum recess 44. The height difference between the maximum protrusion 3 and the maximum recess 4 is taken as the maximum unevenness height 5. The position in the surface normal direction of the highest location in the 6 mm×6 mm portion is the maximum protrusion 3. The position in the surface normal direction of the lowest location in the 6 mm×6 mm portion is the maximum recess depth 4. The maximum unevenness height 5 is represented by the distance in the surface normal direction between the maximum protrusion 3 and the maximum recess depth 4. The surface normal direction is a direction that is perpendicular to the surface 2 when the surface 2 is macroscopically viewed.

The maximum unevenness height 5 of the silicon nitride substrate according to the embodiment is not more than 50 µm. When large, i.e., greater than 50 µm, the maximum unevenness height 5 may cause bonding defects. Also, the maximum unevenness height 5 is not more than 50 µm in any 6 mm×6 mm portion of the surface 2. That is, the maximum unevenness height 5 is not more than 50 µm no matter which 6 mm×6 mm portion is observed.

The size of the observed portion is set to 6 mm×6 mm because the measurement accuracy is good. When the size is excessively greater than 6 mm×6 mm, there is a possibility that waviness of the substrate may be detected, and the measurement accuracy may decrease. When the size is less than 6 mm×6 mm, there is a possibility that the inspection efficiency may be reduced because the number of measurements is increased.

Also, in the silicon nitride substrate 1 according to the embodiment, the first region to the fourth regions are present when the 6 mm×6 mm portion is observed. The first region is a region in which the height ratio with respect to the maximum unevenness height 5 is not less than 0.8 and not more than 1.0. The second region is a region in which the height ratio with respect to the maximum unevenness height 5 is not less than 0.5 but less than 0.8. The third region is a region in which the height ratio with respect to the maximum unevenness height 5 is not less than 0.3 but less than 0.5. The fourth region is a region in which the height ratio with respect to the maximum unevenness height 5 is not less than 0 but less than 0.3.

After the 6 mm×6 mm portion is observed, image analysis of this portion is performed. First, the maximum unevenness height 5 of the 6 mm×6 mm portion is measured. Then, the heights of measurement areas in the 6 mm×6 mm portion are measured. "Measurement area" corresponds to the spot diameter of the laser of the three-dimensional profilometer. "Height" is the position in the surface normal direction of each measurement area when referenced to the maximum recess depth 4. Height of measurement area/maximum unevenness height = height ratio.

For example, the maximum unevenness height 5 is taken to be 30 µm. In such a case, the first region in which the height ratio with respect to the maximum unevenness height 5 is not less than 0.8 and not more than 1.0 is a region in which the height is within the range of not less than 24 µm and not more than 30 µm. The second region in which the height ratio with respect to the maximum unevenness height 5 is not less than 0.5 but less than 0.8 is a region in which the height is within the range of not less than 15 µm but less than 24 µm. The third region in which the height ratio with respect to the maximum unevenness height 5 is not less than 0.3 but less than 0.5 is a region in which the height is within the range of not less than 9 µm but less than 15 µm. The fourth region in which the height ratio with respect to the maximum unevenness height 5 is not less than 0 but less than 0.3 is a region in which the height is within the range of not less than 0 µm but less than 9 µm.

The total of the areas of the first to fourth regions of the 6 mm×6 mm portion is taken as 100%. In such a case, the area ratio of the first region to the total area is not less than 1% and not more than 10%. The area ratio of the second region to the total area is not less than 10% and not more than 50%. The area ratio of the third region to the total area is not less than 20% and not more than 50%; and the area ratio of the fourth region to the total area is not less than 10% and not more than 60%.

When VR-3000 made by Keyence Corporation is used, for example, the first region can be displayed as red; the second region can be displayed as orange or yellow; the third region can be displayed as yellowish green; and the fourth region can be displayed as blue or light blue. The area ratios of the first to fourth regions can be calculated by calculating the areas of the regions respectively illustrated using the colors. To measure the area ratios, it is also effective to use the color mapping function of the three-dimensional profilometer.

FIG. 3 is a plan view showing an example of an unevenness distribution of the surface of the silicon nitride substrate. In FIG. 3, the reference numeral 2 is a surface, the reference numeral 6 is a first region, the reference numeral 7 is a second region, the reference numeral 8 is a third region, and the reference numeral 9 is a fourth region.

In the silicon nitride substrate 1 according to the embodiment, the area ratio of the first region 6 is not less than 1% and not more than 10%. The height ratio of the first region 6 is not less than 0.8 and not more than 1.0; and the first region 6 includes the highest location. That is, the area ratio of the region that is most convex with respect to the maximum recess depth 4 is controlled to be not less than 1% and not more than 10%. To suppress the occurrence of bonding defects, it is effective to control the unevenness distribution rather than control local unevenness as was done conventionally. Bonding defects are caused when the area ratio of the first region 6 is greater than 10% because the area of the region that is most convex with respect to the maximum recess depth 4 is large.

It is important for the second region 7, the third region 8, and the fourth region 9 also to be present with prescribed ratios. As a result, the effects on bonding of unevenness in narrow portions of 6 mm×6 mm can be relaxed. Specifically, the area ratio of the fourth region is not less than 10% and not more than 60%. The height ratio of the fourth region 9 is not less than 0 but less than 0.3; and the fourth region 9 includes the lowest location. When the area ratio of the fourth region is less than 10%, the ratio of local recesses increases, which causes bonding defects. The area ratio of the second region is not less than 10% and not more than 50%. The area ratio of the third region is not less than 20% and not more than 50%. By having the second region and the third region present in such ratios, steep changes of the unevenness of the surface 2 can be suppressed, and the bonding strength can be increased.

Herein, the area of the first region 6 is taken as *A1;* the area of the second region 7 is taken as *A2;* the area of the third region 8 is taken as *A3;* and the area of the fourth region 9 is taken as *A4.* It is favorable for the ratio of the area of the second region 7 to the area of the first region 6 to be within the range of 2 ≤ *A2*/*A1* ≤ 30. That is, the area of the second region 7 is within the range of not less than 2 times and not more than 30 times the area of the first region 6. By having more of the second region 7 present than the first region 6, the first region 6 can be prevented from being an outstanding protrusion.

It is favorable for the area ratios of the second, third, and fourth regions 7, 8, and 9 each to satisfy 3 ≤ (*A3 + A4*)/*A2.* That is, the total area of the third and fourth regions 8 and 9 is not less than 3 times the area of the second region 7. By having more of the third and fourth regions 8 and 9 present than the second region 7, the effects of the second region 7 on the unevenness can be relaxed. Also, further effects can be obtained by combining with 2 ≤ *A2*/*A1* ≤ 30.

When the maximum unevenness height is not less than 5 µm and not more than 25 µm, it is favorable for 0.3 ≤ (*A2 + A3*)/(*A1 + A2 + A3* + *A4*) ≤ 0.6 to be satisfied. The maximum unevenness height 5 being not less than 5 µm and not more than 25 µm indicates that the maximum unevenness height 5 is at a medium level (the unevenness is about medium). In such a case, it is favorable for the percentage of the total area of the second and third regions 7 and 8 within the 6 mm×6 mm area to be within the range of not less than 30% and not more than 60%. The area ratio of the first region 6 is not less than 1% and not more than 10%, and so the remaining portion other than the second region 7 and the third region 8 is the fourth region 9. That is, it is effective to increase the ratio of the fourth region 9 when the maximum unevenness height 5 is not less than 5 µm and not more than 25 µm. The condition of 0.3 ≤ (*A2 + A3*)/(*A1 + A2 + A3* + *A4*) ≤ 0.6 may be combined with one or more conditions selected from 2 ≤ *A2*/*A1* ≤ 30 and 3 ≤ (*A3 + A4*)/*A2.*

When the maximum unevenness height is greater than 25 µm and not more than 50 µm, it is favorable for 0.5 ≤ (*A2 + A3*)/(*A1 + A2 + A3* + *A4*) ≤ 0.8 to be satisfied. The maximum unevenness height 5 being greater than 25 µm and not more than 50 µm indicates that the maximum unevenness height 5 is at a high level (unevenness is large). In such a case, it is favorable for the total area of the second and third regions 7 and 8 to be within the range of not less than 50% and not more than 80% in the 6 mm×6 mm portion. That is, it is effective to increase the total area of the second and third regions 7 and 8 compared to when the maximum unevenness height 5 is at the medium level (not less than 5 µm and not more than 25 µm). The condition of 0.5 ≤ (*A2 + A3*)/(*A1 + A2 + A3 + A4*) ≤ 0.8 may be combined with one or more conditions selected from 2 ≤ *A2*/*A1* ≤ 30 and 3 ≤ (*A3* + *A4*)/*A2.*

It is favorable for both the second and third regions 7 and 8 to be present between the first region 6 and the fourth region 9 in the 6 mm×6 mm portion. More specifically, in the 6 mm×6 mm portion, when the maximum protrusion 3 and the maximum recess 4 are connected by a straight line, it is favorable for both the second and third regions 7 and 8 to be present on the straight line.

For example, in the 6 mm×6 mm portion shown in FIG. 3, the maximum protrusion 3 and the maximum recess 4 are present respectively in the first region 6 and the fourth region 9 positioned proximate to the center. When the maximum protrusion 3 and the maximum recess 4 are connected by a straight line L, both the second and third regions 7 and 8 are present on the straight line L.

The first region 6 is a region in which the height ratio with respect to the maximum unevenness height 5 is not less than 0.8 and not more than 1.0. The fourth region 9 is a region in which the height ratio with respect to the maximum unevenness height 5 is not less than 0 but less than 0.3. The gradient from the highest maximum protrusion 3 toward the lowest maximum recess 4 can be gradual by having both the second and third regions 7 and 8 present between the maximum protrusion 3 and the maximum recess 4. Effects of the unevenness can be reduced thereby.

The effects of the unevenness can be relaxed by controlling the distribution of the first to fourth regions in the 6 mm×6 mm portion. In other words, even when a prescribed unevenness is present, discrepancies can be reduced by controlling the distribution of the first to fourth regions.

It is favorable for the thickness of the silicon nitride substrate 1 to be within the range of not less than 0.2 mm and not more than 3 mm. When the thickness of the substrate is less than 0.2 mm, there is a possibility that the insulative properties may degrade. As described above, an unevenness is present in the surface 2 of the silicon nitride substrate 1 according to the embodiment. When the substrate is too thin, there is a possibility that the effects of the unevenness may be increased, and the insulative properties may be degraded. When the substrate is thick and is greater than 3 mm, the insulative properties are improved, but there is a possibility that the substrate may become a thermal resistor, and the heat dissipation may degrade. It is therefore favorable for the thickness of the silicon nitride substrate 1 to be within the range of not less than 0.2 mm and not more than 3 mm, and more favorably within the range of not less than 0.2 mm and not more than 1 mm.

The specific size of the silicon nitride substrate 1 is arbitrary. For example, the size of the silicon nitride substrate 1 may be not less than 50 mm long and not less than 50 mm wide. When the silicon nitride substrate 1 has a size that is greater than 50 mm long×50 mm wide, a greater effect can be obtained by controlling the unevenness of the 6 mm×6 mm portion. Multi-part manufacturing is possible when the silicon nitride substrate has a large size. Multi-part manufacturing is when the silicon nitride substrate is subdivided into smaller sizes by performing scribing of the silicon nitride substrate. The suitability for mass production can be increased thereby. The scribing may be performed before a metal plate is bonded, or may be performed after the bonding. The effects on the yield are large when bonding defects occur in a silicon nitride substrate having a large size. It is therefore more effective to control the unevenness.

It is favorable for the thermal conductivity of the silicon nitride substrate 1 to be not less than 50 W/m·K, or even not less than 80 W/m·K. The thermal conductivity is measured by the flash method. The thermal conductivity is measured in accordance with JIS-R-1611. JIS-R-1611 corresponds to ISO 18755. It is favorable for the three-point bending strength of the silicon nitride substrate to be not less than 500 MPa, and more favorably not less than 600 MPa. The three-point bending strength is measured in accordance with JIS-R-1601. JIS-R-1601 corresponds to ISO 14704.

The silicon nitride substrate 1 described above can be used in a silicon nitride circuit board on which a circuit part is located. The circuit part can include a metal plate, a metalized layer, a thin film, etc.

Examples of the metal plate include a copper plate (including a copper alloy), an aluminum plate (including an aluminum alloy), etc. The metal plate may be bonded to the silicon nitride substrate 1 via a bonding layer as necessary. Examples of the bonding method include active metal bonding that uses an active metal. When bonding a copper plate, an active metal brazing material that includes an active metal such as Ti or the like is used in the active metal bonding. When bonding an aluminum plate, an active metal brazing material that includes an active metal such as Si or the like is used.

The metalized layer is formed by coating a metal paste to the silicon nitride substrate 1 and by firing. The metalized layer includes, for example, one selected from Ag (silver), Cu (copper), Mo (molybdenum), and W (tungsten) as a major component. The thin film is an electrically-conductive film formed by sputtering or vapor deposition.

FIG. 4 is a side view showing an example of a silicon nitride circuit board according to an embodiment. In FIG. 4, 1 is a silicon nitride substrate, 10 is a silicon nitride circuit board, 11 is a circuit part, 12 is a bonding layer, and 13 is a heat dissipation part. The silicon nitride circuit board 10 includes the silicon nitride substrate 1, and the circuit part 11 located on at least one surface of the silicon nitride substrate 1. In the example shown in FIG. 4, the circuit part 11 is located at the front surface of the silicon nitride substrate 1; and the heat dissipation part 13 is located at the back surface. The circuit part 11 and the heat dissipation part 13 each are bonded to the silicon nitride substrate 1 via the bonding layer 12. For example, a metal-plate circuit part 11 can be located at the front surface; and a metal-plate heat dissipation part 13 can be located at the back surface. The circuit part 11 may be located at two surfaces of the silicon nitride substrate 1 as necessary. Also, the number of the circuit parts 11 located at the surfaces is arbitrary. The number is not limited to the illustrated example; and one circuit part 11 or three or more circuit parts 11 may be located at surfaces.

According to the silicon nitride circuit board 10 according to the embodiment, bonding defects between the surface 2 and the circuit part 11 can be suppressed. Bonding defects after the TCT test also can be reduced. Because the effects of the surface unevenness of the silicon nitride substrate 1 are relaxed, the occurrence of micro gaps at the bonding interface between the silicon nitride substrate 1 and the circuit part 11 can be suppressed. When micro gaps are present at the bonding interface between the silicon nitride substrate 1 and the circuit part 11, there is a possibility that the gaps may become large after the TCT test and cause bonding defects. Bonding defects can be measured by ultrasonic testing (SAT).

Active metal bonding is used when bonding the metal plate. In active metal bonding, the metal plate is bonded with the silicon nitride substrate 1 by coating an active metal brazing material that includes an active metal and by firing. The bonding layer 12 is formed by firing the brazing material layer.

When the unevenness difference of the surface 2 of the silicon nitride substrate 1 is large, it becomes easier for gaps to form between the silicon nitride substrate 1 and the brazing material layer when coating the active metal brazing material. When there are gaps between the silicon nitride substrate 1 and the brazing material layer, it becomes easier for gaps to form between the silicon nitride substrate 1 and the bonding layer 12 as well. For example, an active metal brazing material that includes Ti reacts with the silicon nitride substrate 1 to form a titanium nitride layer. By forming the titanium nitride layer, the silicon nitride substrate 1 and the metal plate are securely bonded. Gaps that are formed between the silicon nitride substrate 1 and the bonding layer 12 unfavorably affect secure bonding. In other words, the embodiment of the invention is favorable for the silicon nitride circuit board 10 in which the metal plate is bonded using active metal bonding. It becomes difficult for gaps to form between the silicon nitride substrate 1 and the bonding layer 12 by controlling the maximum unevenness height 5 of the surface 2 of the silicon nitride substrate 1, the ratios of the first to fourth regions 6 to 9, etc. As a result, the bonding strength between the silicon nitride substrate 1 and the metal plate can be increased.

The silicon nitride circuit board 10 can be used in a semiconductor device to which a semiconductor element is mounted. FIG. 5 is a side view showing an example of a semiconductor device according to an embodiment. In FIG. 5, the reference numeral 10 is a silicon nitride circuit board, the reference numeral 14 is a semiconductor element, and the reference numeral 20 is a semiconductor device. Although an example is shown in FIG. 5 in which one semiconductor element 14 is mounted, multiple semiconductor elements 14 may be mounted. Also, a leadframe or wire bonding, which are not-illustrated, may be included. Sealing may be performed with a resin.

A method for manufacturing the silicon nitride substrate 1 according to the embodiment will now be described. The method for manufacturing the silicon nitride substrate 1 according to the embodiment is not particularly limited as long as the silicon nitride substrate 1 has the characteristics described above. An example of a method for obtaining the silicon nitride substrate 1 with a high yield will now be described.

Manufacturing processes of the silicon nitride substrate include a raw material mixing process, a forming process, a degreasing process, and a sintering process. In the raw material mixing process, a raw material powder is prepared by mixing a silicon nitride powder, which is the major component, and a sintering aid powder. A raw material paste is prepared by mixing an organic binder into the raw material powder. The silicon nitride powder can include both a direct-nitrided powder and an imide decomposition powder. In the forming process, a sheet-like silicon nitride compact is prepared from the raw material paste. Examples of the preparation of the sheet-like silicon nitride compact include a doctor blade technique, die molding, injection molding, etc.

Then, the degreasing process and the sintering process are performed. It is favorable to perform the degreasing process and the sintering process with the sheet-like silicon nitride compact placed on a boron nitride plate. It is favorable for the surface of the boron nitride plate to have no recesses of depth 40 µm or more. Also, it is favorable for the maximum height roughness Rz of the surface of the boron nitride plate to be not more than 40 µm. It is favorable for the warp amount of the boron nitride plate to be not more than 0.1 mm. The warp of the boron nitride plate refers to the greatest distance between the boron nitride plate and a straight line connecting one end portion of the boron nitride plate and an end portion at the opposite side. It is favorable for the warp amount to be not more than 0.2 mm for each of the long-side direction, short-side direction, and diagonal direction of the boron nitride plate.

In the degreasing process, the binder is removed from the sheet-like silicon nitride compact. The sheet-like silicon nitride compact is called a silicon nitride compact. The silicon nitride compact is placed on the boron nitride plate. A single-layer silicon nitride compact may be placed, or multiple silicon nitride compacts may be placed by stacking. A weight board may be placed on the silicon nitride compact. A stacked structure of boron nitride plates and silicon nitride compacts may be used, such as boron nitride plate/silicon nitride compact/boron nitride plate/silicon nitride compact. When silicon nitride compacts are stacked with each other, a bed powder may be used between the silicon nitride compacts. It is favorable for the bed powder to be a boron nitride powder having an average particle size of not more than 10 µm. When the bed powder has a small particle size, the surface unevenness of the silicon nitride substrate 1 can be reduced. It is therefore favorable for the average particle size of the bed powder to be not more than 10 µm, and more favorably not more than 6 µm. Also, the effect of suppressing the warp of the silicon nitride substrate 1 is obtained by using the weight board. Similarly, the effect of suppressing warp of the silicon nitride substrate 1 also is obtained by using a stacked structure of boron nitride plates and silicon nitride compacts.

It is favorable to perform the degreasing process within the range of not less than 350 °C and not more than 600 °C. The organic binder is removed from the silicon nitride compact by the degreasing process. A silicon nitride degreased body is obtained by the degreasing process.

The silicon nitride degreased body is sintered in the sintering process. It is favorable to perform the sintering process within the range of not less than 1,600 °C and not more than 2,000 °C. Examples of the atmosphere of the sintering process include a vacuum, ambient air, an inert atmosphere, etc. The pressure of the sintering process is set to atmospheric pressure, is pressurized, etc.

The silicon nitride substrate 1 can be obtained by the processes described above. The removal process of the bed powder, the cleaning process, the warp correction process, etc., may be performed as necessary. The surfaces of the silicon nitride substrates 1 may be inspected; and only the silicon nitride substrates 1 included in the embodiment may be sorted.

### (Examples)

### (Examples 1 to 7 and Comparative Examples 1 to 2)

A raw material powder was prepared in which a silicon nitride powder and a sintering aid were mixed. A binder and the like were added to the raw material powder; and a sheet-like silicon nitride compact was made by doctor blade. A degreasing process and a sintering process of the sheet-like silicon nitride compact were performed using a boron nitride plate and a boron nitride bed powder. The degreasing process was performed within the range of not less than 350 °C and not more than 600 °C. The sintering process was performed within the range of not less than 1,600 °C and not more than 2,000 °C. A silicon nitride substrate was obtained thereby. The size of the silicon nitride substrate was 120 mm long×100 mm wide. The boron nitride plates and the boron nitride bed powders that were used were as shown in Table 1.

**[Table 1]**

| | Boron nitride plate | | | Boron nitride bed powder |
|---|---|---|---|---|
| | Presence of recess having depth of 40 µm or more | Maximum height roughness Rz (µm) | Warp amount (mm) | Average particle size (µm) |
| Example 1 | No | ≦40 | ≦0. 1 | ≦ 6 |
| Comparative Example 1 | Yes | 58 | ≦ 0.1 | 15 |
| Comparative Example 2 | No | ≦40 | 0. 3 | ≦6 |

Favorable manufacturing conditions were satisfied in the examples. In Comparative Example 1, the warp of the boron nitride plate was small, but the unevenness was large. Also, the average particle size of the bed powder was larger in Comparative Example 1 than the examples. In Comparative Example 2, the unevenness of the boron nitride plate was small, but the warp amount was large.

The surface unevenness was inspected for the silicon nitride substrates that were obtained. Multiple 6 mm×6 mm portions of the surface of the silicon nitride substrate were randomly selected; and the unevenness of each portion was observed. A three-dimensional profilometer (VR-3000 made by Keyence Corporation) was used to observe the unevenness. The methods for measuring the maximum unevenness height and area ratios of the first to fourth regions were as described above. The area ratios of the first to fourth regions were calculated by using the sum of the areas of the first to fourth regions as 100%. The results are shown in Table 2. In Table 2, "YES" indicates that the area ratio of the region was within the prescribed range. "NO" indicates that the area ratio of the region was outside the prescribed range.

**[Table 2]**

| | Maximum unevenness height (µm) | Area ratio | | | |
|---|---|---|---|---|---|
| | | Area ratio of first region 1-10% | Area ratio of second region 10-50% | Area ratio of third region 20-50% | Area ratio of fourth region 10-60% |
| Example 1 | ≦50 | YES | YES | YES | YES |
| Comparative Example 1 | 83 | YES | YES | YES | YES |
| Comparative Example 2 | 550 | NO(15%) | NO(5%) | YES | YES |

In the examples, the maximum unevenness height was not more than 50 µm for each 6 mm×6 mm portion; and the area ratio of each region was within the prescribed range. In the examples, the maximum unevenness height and the area ratio satisfied the favorable conditions. In Example 1, there was a mixture of regions in which the maximum unevenness height was not less than 5 µm and not more than 25 µm and regions in which the maximum unevenness height was greater than 25 µm and not more than 50 µm. In Comparative Example 1, a portion was present in which the maximum unevenness height was 83 µm. In other words, in Comparative Example 1, the area ratio of each region was within the prescribed range, but portions were present in which the maximum unevenness height was greater than 50 µm. In Comparative Example 2, the area ratio of the first region was 15%; and the area ratio of the second region was 5%. In other words, in Comparative Example 2, the maximum unevenness height was 50 µm, but portions were present in which the area ratio of the first region and the area ratio of the second region were outside the range.

Then, the silicon nitride substrates according to Example 1 were classified according to the relationship of the area ratios of the regions. Specifically, the area of the first region 6 was taken as *A1*; the area of the second region 7 was taken as *A2;* the area of the third region 8 was taken as *A3;* and the area of the fourth region 9 was taken as *A4.* In such a case, it was determined whether or not the conditions of 2 ≤ *A2*/*A1* ≤ 30, 3 ≤ (*A3* + *A4*)/*A2,* 0.3 ≤ (*A2 + A3*)/(*A1 + A2 + A3 + A4*) ≤ 0.6, and 0.5 ≤ (*A2 + A3*)/(*A1 + A2 + A3 + A4*) ≤ 0.8 were satisfied for each substrate. Also, it was determined whether or not both the second and third regions were present between the maximum protrusion and the maximum recess. Example 1 was classified into Examples 2 to 7 according to whether or not each condition was satisfied. The results are shown in Table 3. In Table 3, "YES" indicates that a condition was satisfied; and "NO" indicates that a condition was not satisfied. The condition of 0.3 ≤ (*A2 + A3*)/(*A1 + A2 + A3 + A4*) ≤ 0.6 was determined for Examples 2 to 4, of which the maximum unevenness heights were not less than 5 µm and not more than 25 µm. The condition of 0.5 ≤ (*A2 + A3*)/(*A1 + A2 + A3* + *A4*) ≤ 0.8 was determined for Examples 5 to 7, of which the maximum unevenness heights were greater than 25 µm and not more than 50 µm.

**[Table 3]**

| | Maximum unevenness height | 2≦A2/ A1≦30 | 3≦(A3+A4)/ A2 | 0.3≦ (A2*+*A3)/ (A1+A2+A3+A4) ≦0.6 | 0.5 ≦(A2+A3)/ (A1+A2+A3+A4) ≦0.8 | Second region and third region present on straight line |
|---|---|---|---|---|---|---|
| Example 2 | Not less than 5 µm and not more than 25 µm | YES | YES | YES | - | YES |
| Example 3 | Not less than 5 µm and not more than 25 µm | YES | NO | YES | - | YES |
| Example 4 | Not less than 5 µm and not more than 25 µm | YES | YES | NO | - | YES |
| Example 5 | Greater than 25 µm and not more than 50 µm | YES | YES | - | YES | YES |
| Example 6 | Greater than 25 µm and not more than 50 µm | YES | NO | - | YES | YES |
| Example 7 | Greater than 25 µm and not more than 50 µm | YES | YES | - | NO | YES |

Also, Table 4 shows the measurement results of the maximum unevenness height and area ratios of the first to fourth regions for arbitrary 6 mm×6 mm portions of the silicon nitride substrates according to Examples 2 to 7.

**[Table 4]**

| | Maximum unevenness height (µm) | Area ratio | | | |
|---|---|---|---|---|---|
| | | Area ratio of one region (%) | Area ratio of second region (%) | Area ratio of third region (%) | Area ratio of fourth region (%) |
| Example 2 | 7 | 2 | 20 | 37 | 41 |
| Example 3 | 13 | 5 | 30 | 29 | 36 |
| Example 4 | 23 | 7 | 21 | 47 | 25 |
| Example 5 | 27 | 4 | 18 | 60 | 18 |
| Example 6 | 38 | 8 | 31 | 25 | 36 |
| Example 7 | 44 | 4 | 17 | 68 | 11 |

Then, metal plates were bonded by active metal bonding respectively to the front surface and back surface of the silicon nitride substrate. A copper plate that had a thickness of 0.8 mm was bonded to the front surface to form a circuit part. A copper plate that had a thickness of 0.8 mm was bonded to the back surface as a heat dissipation plate. A brazing material that included Ti as an active metal was used as the active metal brazing material. The circuit part was formed by etching the copper plate of the front surface to provide a circuit configuration. The silicon nitride circuit board was made by these processes.

The presence of bonding defects was checked for the silicon nitride circuit boards according to the examples and the comparative examples. Bonding defects were checked by ultrasonic testing (SAT). Examples in which the area ratio of bonding defects of the circuit part was not less than 0% and not more than 1% were taken as "excellent". Examples in which the area ratio of bonding defects was greater than 1% and not more than 3% were taken as "good". Examples in which the area ratio of bonding defects was greater than 3% and not more than 5% were taken as "acceptable". Examples in which the area ratio of bonding defects was greater than 5% were taken as "unacceptable". The area ratio of bonding defects was measured for ten silicon nitride circuit boards for each of the examples and the comparative examples; and the results with the greatest area ratios of bonding defects were recorded.

Also, the bonding defects after performing a TCT test were checked. In the TCT test, the area ratio of bonding defects was measured after 4,000 cycles, wherein one cycle was 30 minutes at -40 °C, 10 minutes at room temperature, 30 minutes at 150 °C, and 10 minutes at room temperature. The area ratio of bonding defects was measured for ten silicon nitride circuit boards for each of the examples and the comparative examples, and the results with the greatest area ratio of bonding defects were recorded. Table 5 shows the results.

| | Bonding defects before TCT test | Bonding defects after TCT test |
|---|---|---|
| Example 1 | Good | Acceptable |
| Example 2 | Excellent | Excellent |
| Example 3 | Excellent | Good |
| Example 4 | Excellent | Good |
| Example 5 | Excellent | Excellent |
| Example 6 | Excellent | Good |
| Example 7 | Excellent | Good |
| Comparative Example 1 | Unacceptable | Unacceptable |
| Comparative Example 2 | Acceptable | Unacceptable |

It can be seen from Table 5 that the bonding defects were decreased for the silicon nitride circuit boards according to the examples. In particular, in Example 2 and Example 5 in which all of the favorable conditions were satisfied, the area ratios of bonding defects were small even after the TCT test; and a reduction of the bonding strength due to TCT was suppressed. In contrast, in Comparative Example 1, the maximum unevenness height was large, and so the area ratio of bonding defects was large at the stage before the TCT test. In Comparative Example 2, the maximum unevenness height was small, but the ratio of the first region and the second region was outside the favorable range. Therefore, the area ratio of bonding defects was relatively large at the stage before the TCT test; and the area ratio was further increased by the TCT test.

Embodiments of the invention include the following features.

### Feature 1

A silicon nitride substrate,
when an unevenness of a portion of at least one surface of the silicon nitride substrate is observed, a maximum unevenness height being not more than 50 µm, the portion being 6 mm×6 mm, the maximum unevenness height being a difference between a height of a maximum protrusion and a depth of a maximum recess,
the portion including
   a first region in which a height ratio with respect to the maximum unevenness height is not less than 0.8 and not more than 1.0,
   a second region in which the height ratio is not less than 0.5 but less than 0.8,
   a third region in which the height ratio is not less than 0.3 but less than 0.5, and
   a fourth region in which the height ratio is not less than 0 but less than 0.3,
a ratio of an area of the first region to a total area of the first to fourth regions being not less than 1% and not more than 10%,
a ratio of an area of the second region to the total area being not less than 10% and not more than 50%,
a ratio of an area of the third region to the total area being not less than 20% and not more than 50%,
a ratio of an area of the fourth region to the total area being not less than 10% and not more than 60%.

### Feature 2

The silicon nitride substrate according to Feature 1, wherein
2 ≤ the area of the second region/the area of the first region ≤ 30 is satisfied.

### Feature 3

The silicon nitride substrate according to Feature 1 or Feature 2, wherein
3 ≤ (the area of the third region + the area of the fourth region)/the area of the second region is satisfied.

### Feature 4

The silicon nitride substrate according to any one of Features 1 to 3, wherein
the maximum unevenness height is not less than 5 µm and not more than 25 µm, and
0.3 ≤ (the area of the second region + the area of the third region)/the total area ≤ 0.6 is satisfied.

### Feature 5

The silicon nitride substrate according to any one of Features 1 to 3, wherein
the maximum unevenness height is greater than 25 µm and not more than 50 µm, and
0.5 ≤ (the area of the second region + the area of the third region)/the total area ≤ 0.8 is satisfied.

### Feature 6

The silicon nitride substrate according to any one of Features 1 to 5, wherein
in the portion, when the maximum protrusion and the maximum recess are connected by a straight line, both the second and third regions are present on the straight line.

### Feature 7

The silicon nitride substrate according to any one of Features 1 to 6, wherein
a substrate thickness of the silicon nitride substrate is not less than 0.2 mm and not more than 3 mm.

### Feature 8

The silicon nitride substrate according to Feature 7, wherein
the silicon nitride substrate has a longitudinal dimension of not less than 50 mm, and a lateral dimension of not less than 50 mm.

### Feature 9

A silicon nitride circuit board, comprising:
the silicon nitride substrate according to any one of Features 1 to 8; and
a circuit part located on the silicon nitride substrate.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments herein may be made without departing from the spirit of the inventions. The accompanying claims and their equivalents are intended to cover such forms or modifications as would fall within the scope and spirit of the inventions. Also, the embodiments above can be implemented in combination with each other.

### [Reference Numeral List]

1 silicon nitride substrate
2 surface
3 maximum protrusion
4 maximum recess
5 maximum unevenness height
6 first region
7 second region
8 third region
9 fourth region
10 silicon nitride circuit board
11 circuit part
12 bonding layer
13 heat dissipation part
14 semiconductor element
20 semiconductor device

## Claims

1. A silicon nitride substrate,
when an unevenness of a portion of at least one surface of the silicon nitride substrate is observed, a maximum unevenness height being not more than 50 µm, the portion being 6 mm×6 mm, the maximum unevenness height being a difference between a height of a maximum protrusion and a depth of a maximum recess,
the portion including
a first region in which a height ratio with respect to the maximum unevenness height is not less than 0.8 and not more than 1.0,
a second region in which the height ratio is not less than 0.5 but less than 0.8,
a third region in which the height ratio is not less than 0.3 but less than 0.5, and
a fourth region in which the height ratio is not less than 0 but less than 0.3,
a ratio of an area of the first region to a total area of the first to fourth regions being not less than 1% and not more than 10%,
a ratio of an area of the second region to the total area being not less than 10% and not more than 50%,
a ratio of an area of the third region to the total area being not less than 20% and not more than 50%,
a ratio of an area of the fourth region to the total area being not less than 10% and not more than 60%.

2. The silicon nitride substrate according to claim 1, wherein
2 ≤ the area of the second region/the area of the first region ≤ 30 is satisfied.

3. The silicon nitride substrate according to claim 1 or claim 2, wherein
3 ≤ (the area of the third region + the area of the fourth region)/the area of the second region is satisfied.

4. The silicon nitride substrate according to claim 1 or claim 2, wherein
the maximum unevenness height is not less than 5 µm and not more than 25 µm, and
0.3 ≤ (the area of the second region + the area of the third region)/the total area ≤ 0.6 is satisfied.

5. The silicon nitride substrate according to claim 3, wherein
the maximum unevenness height is not less than 5 µm and not more than 25 µm, and
0.3 ≤ (the area of the second region + the area of the third region)/the total area ≤ 0.6 is satisfied.

6. The silicon nitride substrate according to claim 1 or claim 2, wherein
the maximum unevenness height is greater than 25 µm and not more than 50 µm, and
0.5 ≤ (the area of the second region + the area of the third region)/the total area ≤ 0.8 is satisfied.

7. The silicon nitride substrate according to claim 3, wherein
the maximum unevenness height is greater than 25 µm and not more than 50 µm, and
0.5 ≤ (the area of the second region + the area of the third region)/the total area ≤ 0.8 is satisfied.

8. The silicon nitride substrate according to claim 1 or claim 2, wherein
in the portion, when the maximum protrusion and the maximum recess are connected by a straight line, both the second and third regions are present on the straight line.

9. The silicon nitride substrate according to claim 5, wherein
in the portion, when the maximum protrusion and the maximum recess are connected by a straight line, both the second and third regions are present on the straight line.

10. The silicon nitride substrate according to claim 7, wherein
in the portion, when the maximum protrusion and the maximum recess are connected by a straight line, both the second and third regions are present on the straight line.

11. The silicon nitride substrate according to claim 1 or claim 2, wherein
a substrate thickness of the silicon nitride substrate is not less than 0.2 mm and not more than 3 mm.

12. The silicon nitride substrate according to claim 5, wherein
a substrate thickness of the silicon nitride substrate is not less than 0.2 mm and not more than 3 mm.

13. The silicon nitride substrate according to claim 8, wherein
a substrate thickness of the silicon nitride substrate is not less than 0.2 mm and not more than 3 mm.

14. The silicon nitride substrate according to claim 11, wherein
the silicon nitride substrate has a longitudinal dimension of not less than 50 mm, and a lateral dimension of not less than 50 mm.

15. The silicon nitride substrate according to claim 12, wherein
the silicon nitride substrate has a longitudinal dimension of not less than 50 mm, and a lateral dimension of not less than 50 mm.

16. The silicon nitride substrate according to claim 13, wherein
the silicon nitride substrate has a longitudinal dimension of not less than 50 mm, and a lateral dimension of not less than 50 mm.

17. A silicon nitride circuit board, comprising:
the silicon nitride substrate according to claim 1 or claim 2; and
a circuit part located on the silicon nitride substrate.

18. A silicon nitride circuit board, comprising:
the silicon nitride substrate according to claim 12; and
a circuit part located on the silicon nitride substrate.

19. A silicon nitride circuit board, comprising:
the silicon nitride substrate according to claim 13; and
a circuit part located on the silicon nitride substrate.
